**Europäisches Patentamt**

**European Patent Office**

**Office européen des brevets**

(19)

(11) Numéro de publication: **0 222 668 B1**

(12) **FASCICULE DE BREVET EUROPEEN**

(45) Date de publication du fascicule du brevet:
**25.04.90**

(51) Int. Cl.⁴: **H01L 21/84, H01L 29/78**

(21) Numéro de dépôt: **86402497.1**

(22) Date de dépôt: **07.11.86**

(54) **Procédé de fabrication par gravure en escalier d'un transistor en couches minces à grille auto-alignée par rapport au drain et à la source de celui-ci et transistor obtenu par ce procédé.**

(30) Priorité: **15.11.85 FR 8516922**

(43) Date de publication de la demande:
**20.05.87 Bulletin 87/21**

(45) Mention de la délivrance du brevet:
**25.04.90 Bulletin 90/17**

(84) Etats contractants désignés:
**CH DE GB IT LI NL**

(56) Documents cités:
**EP-A- 0 076 587**
**EP-A- 0 102 802**
**EP-A- 0 139 585**

**IEEE TRANSACTIONS ON ELECTRON DEVICES, vol. ED-29, no. 11, novembre 1982, pages 1798-1805, IEEE, New York, US; J.J. WYSOCKI: "Drain-current distortion in CdSe thin-film transistors"**

(73) Titulaire: **COMMISSARIAT A L'ENERGIE ATOMIQUE, 31/33, rue de la Fédération, F-75015 Paris(FR)**

(72) Inventeur: **Diem, Bernard, 63, rue des Aiguinards, F-38240 Meylan(FR)**

(74) Mandataire: **Mongrédien, André et al, c/o BREVATOME 25, rue de Ponthieu, F-75008 Paris(FR)**

**Description**

La présente invention a pour objet un procédé de fabrication par gravure d'un transistor en couches minces à grille auto-alignée par rapport au drain et à la source de celui-ci et le transistor obtenu par ce procédé.

D'une façon générale, elle permet la fabrication des composants semi-conducteurs en couches minces pouvant servir au multiplexage de tels composants disposés sous forme matricielle, ainsi qu'à la réalisation de dispositifs à transfert de charge (DTC) ou (CCD charge coupled device en terminologie anglo-saxonne).

Plus particulièrement, elle permet la fabrication de transistors en couches minces (TCM en abrégé) pouvant servir en optoélectronique à la réalisation de la mémoire électronique des écrans plats à cristaux liquides. Cette mémoire électronique qui stocke le signal vidéo pendant toute la durée de l'image est réalisée, sous forme de matrice active, de points mémoires constitués chacun d'un TCM et d'un condensateur et répartis sur toute la surface de l'écran. Le cristal liquide est en contact avec chaque point mémoire et est excité pendant toute la durée d'une image.

Un transistor en couches minces est un transistor à effet de champ à grille isolée. Il s'apparente au transistor MOS (métal-oxyde-semiconducteur) avec cette différence qu'il est réalisé sur un substrat amorphe et non sur une plaquette de silicium monocristallin. De ce fait, comme ils ne sont plus limités par la taille du substrat cristallin, les circuits à TCM peuvent alors présenter de très grandes dimensions.

On connaît par la publication de brevet FR-A-2 553 579 un procédé de fabrication de transistor en couches minces permettant notamment d'aligner la grille du transistor avec le drain et la source de celui-ci. Malheureusement, les flancs de la première couche de silicium, après la photogravure de celle-ci, sont verticaux et n'offrent pas ainsi une bonne surface de contact et d'accrochage pour le dépôt d'une seconde couche de silicium de type n+ en vue de réaliser des contacts ohmiques.

Le but de l'invention est précisément d'améliorer la surface de contact des flancs d'une couche d'un matériau de nature principalement conductrice ou semi-conductrice, par gravure en escalier de telle sorte que le dépôt d'une autre couche d'un matériau de nature principalement conductrice ou semi-conductrice soit meilleur, notamment en vue de réaliser des contacts ohmiques.

Ce but est atteint, selon l'invention, par la réalisation d'un certain nombre de marches d'escalier, sur les flancs de la couche du matériau par un nombre égal de gravures successives et partielles de cette couche, la résine restante servant à chaque fois de masque et étant elle-même gravée de façon isotrope sur une faible épaisseur à l'issue de chaque gravure de la couche du matériau.

Par gravure, l'homme du métier désigne le fait d'ôter de façon sélective par attaque chimique, une épaisseur de couche d'un matériau. Généralement, une couche de résine photosensible joue le rôle de masque à ladite gravure afin d'obtenir la forme souhaitée de la couche.

De façon plus précise, l'invention a pour objet un procédé de fabrication d'un transistor en couches minces, à grille auto-alignée par rapport au drain et à la source de celui-ci, conforme à la revendication 1.

La présente invention a également pour objet un transistor en couches minces à grille auto-alignée, conforme à la revendication 2.

Il est possible, selon l'invention, d'obtenir une surface de contact dont la qualité est fonction du nombre et de la forme des marches que l'on peut réaliser sur les flancs de la couche.

Les limites de cette réalisation sont définies essentiellement par la technique de gravure employée et les épaisseurs des couches du matériau et de la résine présentes. Ce résultat est obtenu grâce à la gravure de la première couche de silicium qui constitue l'étape essentielle et nouvelle de l'invention par rapport à l'enseignement du document FR-A-2 553 579.

Les marches d'escalier obtenues sur les flancs de la première couche de silicium ont une longueur égale à l'épaisseur de la résine enlevée par une gravure isotrope ayant lieu à l'issue de chaque gravure de cette couche de silicium.

On note également que l'obtention des marches d'escalier est réalisée sur la même couche de matériau. Cette unicité favorise la mise en oeuvre du procédé et n'engendre pas d'étape critique.

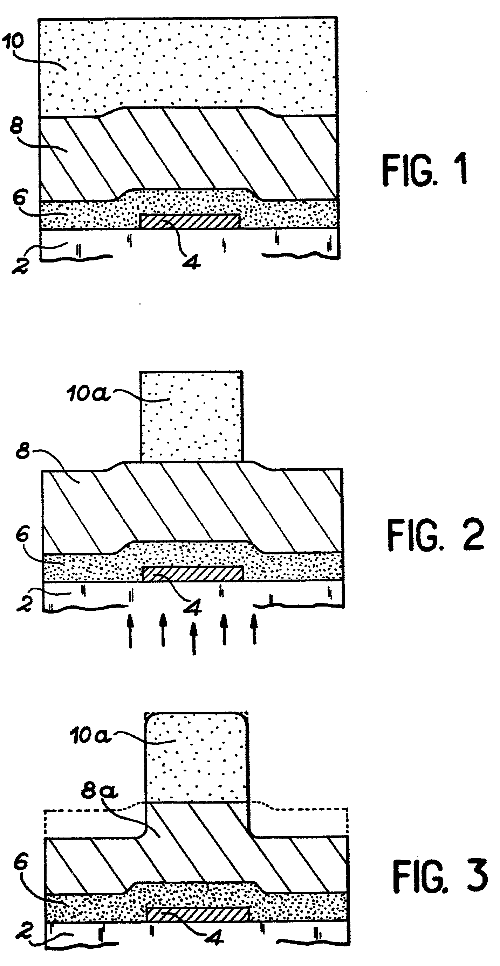

Les caractéristiques de l'invention apparaîtront mieux après la description qui suit, d'un exemple de réalisation donné à titre explicatif et nullement limitatif, en référence aux figures 1 à 9 annexées, qui illustrent les différentes étapes du procédé selon l'invention.

Comme représenté sur la figure 1, la première étape du procédé consiste à réaliser, sur un substrat en verre 2, la grille 4 du transistor en utilisant les procédés classiques de la photolithographie (masquage et gravure). Cette grille 4, présentant par exemple une épaisseur de 100 nm est réalisée de préférence en chrome.

On dépose ensuite, sur le substrat 2 et la grille 4 du transistor, une couche d'isolant, réalisée de préférence en oxyde de silicium. Cette couche d'isolant 6 présentant par exemple une épaisseur de 100 nm peut être obtenue par la technique de dépôt chimique en phase vapeur, à basse pression ou non, ou bien par la technique de décharge luminescente, dans un appareil à radiofréquence, en utilisant un mélange gazeux de $SiH_4$ et de $O_2$.

On dépose ensuite, sur la couche d'isolant 6, une première couche de silicium amorphe hydrogéné 8 épaisse, présentant avantageusement une épaisseur variant de 70 à 100 nm ou voisine de 80 nm. Cette couche de silicium peut être obtenue par la technique de décharge luminescente en utilisant le gaz $SiH_4$.

L'étape suivante du procédé consiste à déposer, sur la couche de silicium amorphe épaisse 8, une couche de résine photosensible positive 10.

Cette couche de résine peut présenter avantageusement une épaisseur variant de 1 000 à 1 200 nm et peut être notamment déposée par centrifugation. Comme résine, on peut utiliser des résines à base de phénolformaldéhyde comme celle vendue par la société HUNT sous la référence HPR 204.

Comme représenté par la figure 2, la couche de résine photosensible 10 est ensuite irradiée à travers le substrat 2, la grille 4 servant alors de masque à l'irradiation. L'utilisation d'une résine sensible dans le visible permet de diminuer la durée de cette irradiation (les flèches portées sur la figure 2 indiquent le sens de l'irradiation).

Le développement de la couche de résine permet de ne garder de cette couche que la zone 10a située au droit de la grille du transistor, les zones irradiées étant éliminées.

L'étape suivante, caractéristique de l'invention est la gravure particulière de la première couche de silicium 8 qui permet de réaliser un certain nombre de marches d'escalier sur les flancs de cette couche de silicium. Les différentes opérations réalisées lors de cette gravure particulière, sont représentées sur les figures 3 à 7 par des pointillés qui permettent ainsi de suivre l'évolution du procédé. Comme représenté sur la figure 3, on procède tout d'abord pendant une durée voisine de 30 minutes, au recuit de la résine 10a à une température comprise entre 100 et 150°C et de préférence voisine de 130°C, pour obtenir un fluage de celle-ci.

Ensuite, on grave une partie de l'épaisseur de la couche de silicium amorphe hydrogéné 8, la résine restante 10a servant de masque ladite gravure. Il subsiste, après cette première gravure partielle, une couche de silicium 8a.

De préférence, la gravure employée est une gravure sèche, utilisant un plasma d'hexafluorure de soufre. De préférence, la gravure partielle est au minimum égale au tiers de l'épaisseur de la couche de silicium amorphe hydrogéné initiale.

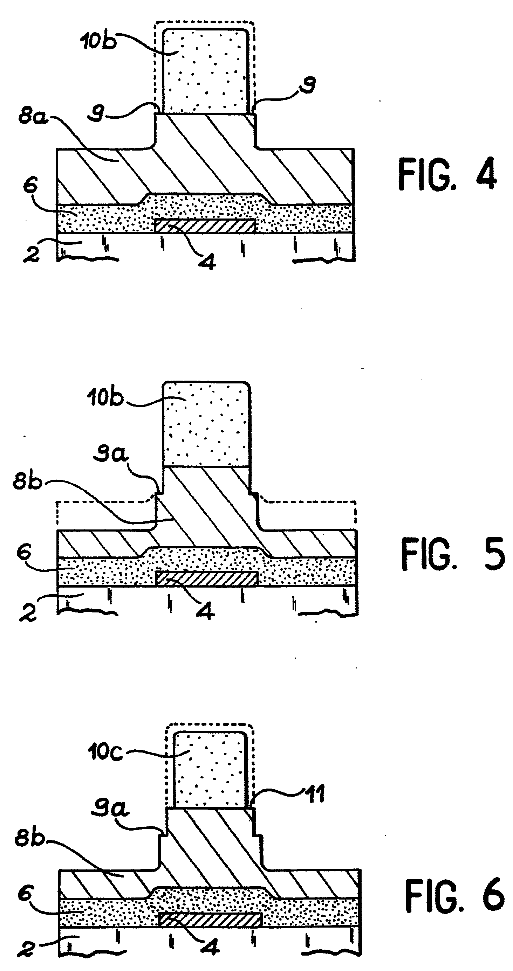

Comme représenté sur la figure 4, le procédé objet de l'invention consiste ensuite à graver de façon isotrope, une faible épaisseur de résine. La gravure fait apparaître sur le sommet des flancs de la couche de silicium 8a, un premier décrochement 9 de largeur égale à celle de la couche de résine gravée.

De préférence, la gravure employée est une gravure sèche, ionique et réactive et la résine restante 10b a une épaisseur inférieure de l'ordre de 150 nm par rapport à celle de la résine initiale 10a de la figure 3.

Comme représenté sur la figure 5, on renouvelle la gravure d'une partie de l'épaisseur de la couche de silicium, la résine restante 10b servant de masque à ladite gravure. Cette seconde gravure partielle attaque de la même façon le décrochement 9 et fait apparaître une première marche 9a sur les flancs de la couche de silicium restante 8b.

Comme représenté sur la figure 6, on renouvelle, de façon identique la gravure isotrope, d'une faible épaisseur de résine 10b, laquelle gravure faisant apparaître un second décrochement 11 sur le sommet des flancs de la couche de silicium 8b, de même longueur que l'épaisseur de la couche de résine gravée.

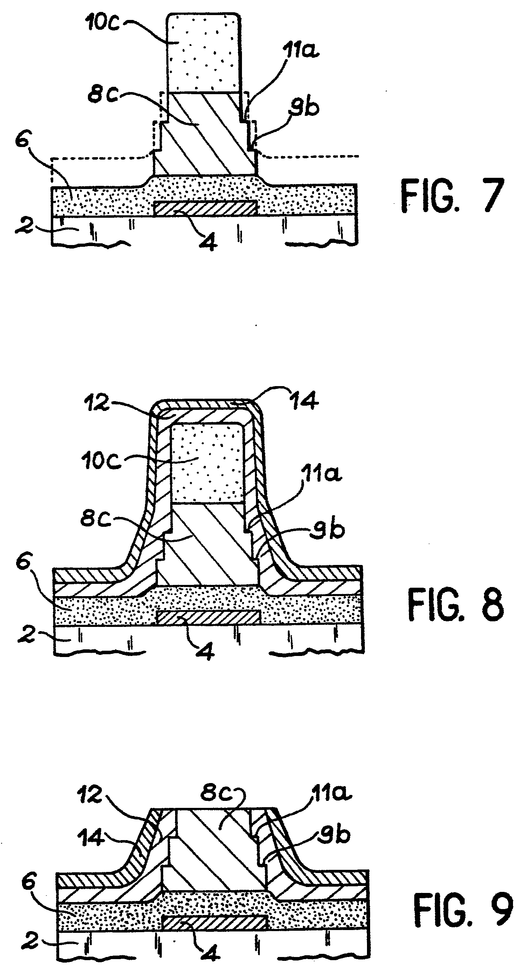

Comme représenté sur la figure 7, l'opération de gravure de la couche de silicium est renouvelée jusqu'à mise à nu de la couche d'isolant 6, la résine restante 10c servant de masque à ladite gravure. Cette dernière gravure partielle attaque de la même façon le décrochement 11 et la marche 9a (Fig.6) et fait apparaître une seconde marche 11a qui s'ajoute à la première marche 9b sur les flancs de la couche de silicium restante 8c (Fig.7).

Dans l'exemple de mise en oeuvre décrit en se référant aux figures 3 à 7, on a réalisé dans la couche de silicium deux marches successives. Il doit être bien entendu que ceci est un exemple préférentiel mais non limitatif et que l'on pourrait tout aussi bien, sans sortir du cadre de l'invention, étendre le procédé à la réalisation d'un nombre de marches supérieur à deux.

Dans tous les cas, il est préférable pour des raisons de simplicité de mise en oeuvre technologique, que toutes les gravures réalisées dans la couche de silicium d'une part et dans la résine d'autre part, soient effectuées repectivement selon des méthodes identiques. (De préférence gravure sèche, en utilisant un plasma d'hexafluorure de soufre pour la couche de silicium, et un plasma d'oxygène pour la résine).

Comme représenté sur la figure 8, on parachève la fabrication de transistor en déposant de façon connue sur l'ensemble de la structure, une seconde couche de silicium amorphe 12 de type n+ hydrogéné ou non, présentant par exemple une épaisseur de 20 nm. Cette seconde couche de silicium 12, déposée par la même technique que celle utilisée pour la première couche de silicium, permet la réalisation de contacts ohmiques pour la source et le drain du transistor. Cette couche 12 est ensuite recouverte d'une couche conductrice 14 réalisée de préférence en chrome. Cette couche conductrice 14 présentant par exemple une épaisseur de 150 nm, est obtenue par dépôt, par exemple par évaporation sous vide ou par pulvérisation.

Comme représenté sur la figure 9, au moyen de la technique connue sous l'expression anglo-saxonne "lift off", on élimine les régions respectivement de la couche conductrice 14 et de la seconde couche de silicium 12, situées au droit de la grille 4 du transistor et la résine restante 10c.

On réalise enfin, dans ce qui reste de la couche conductrice 14, les électrodes de la source, drain du transistor par les procédés classiques de photolithographie (masquage et gravure).

**Revendications**

1. Procédé de fabrication, par gravure, d'un transistor en couches minces à grille auto-alignée par rapport au drain et à la source de celui-ci comprenant les étapes successives suivantes :

a) réalisation sur un substrat en verre (2) de la grille (4) du transistor ;

b) dépôt, sur le substrat (2) et la grille (4), d'une couche d'isolant (6) ;

c) dépôt, sur la couche d'isolant (6), d'une couche de silicium amorphe hydrogéné (8) épaisse ;

d) dépôt, sur cette couche de silicium (8), d'une couche de résine photosensible positive (10) ;

e) irradiation de la couche de résine (10) à travers le substrat (2), la grille (4) servant de masque à l'irradiation ;

f) développement de la couche de résine (10), conduisant à l'élimination des zones irradiées de ladite couche de résine ;

g) gravure de la couche de silicium (8) jusqu'à mise à nu de la couche d'isolant (6), la résine restante (10a,b,c) servant de masque à ladite gravure ;

h) réalisation des contacts électriques et des électrodes de la source et du drain du transistor ; et

i) élimination de la résine restante (10c) ; caractérisé en ce que, au cours de l'étape (g) on réalise un certain nombre de marches d'escalier, sur les flancs de la couche de silicium (8) par un nombre égal de gravures successives et partielles de cette couche de silicium (8), la résine restante (10a) servant à chaque fois de masque et étant elle-même gravée de façon isotrope sur une faible épaisseur à l'issue de chaque gravure de la couche de silicium (8), les marches d'escalier obtenues ayant une longueur égale à l'épaisseur de la résine enlevée par la gravure isotrope.

2. Transistor en couches minces à grille auto-alignée par rapport au drain et à la source de celui-ci obtenu par le procédé de la revendication 1, comprenant :

a) sur un substrat de verre (2), la grille (4) du transistor ;

b) sur le substrat (2) et la grille (4), une couche d'isolant (6) ;

c) sur la couche d'isolant (6), une première couche de silicium amorphe hydrogéné (8) ;

d) sur les flancs de la première couche de silicium (8), des secondes couches de silicium amorphe hydrogéné de type n+ (12) pour la réalisation des contacts électriques ;

e) sur les secondes couches de silicium (12), des couches conductrices (14) pour la réalisation des électrodes de la source et du drain dudit transistor ;

caractérisé par le fait que les premières couches de silicium amorphe hydrogéné (8) présentent des flancs en escalier constitués d'au moins deux marches.

**Claims**

1. Process for producing by stepped etching a thin film transistor with a self-aligned gate with respect to its drain and source and comprising the following successive stages:

a) producing the transistor gate (4) on a glass substrate (2);

b) deposition of an insulating layer (6) on the substrate (2) and gate (4);

c) deposition of a thick hydrogenated amorphous silicon layer (8) on the insulating layer (6);

d) deposition of a positive photosensitive resin layer (10) on the silicon layer (8);

e) irradiation of the resin layer (10) through the substrate (2), the gate (4) serving as an irradiation mask;

f) development of the resin layer (10) leading to the elimination of the irradiated zones of said resin layer;

g) etching the silicon layer (8) until the insulating layer (6) is exposed, the remaining resin (10a, b, c) serving as a mask for said etching;

h) producing electric contacts and source and drain electrodes of transistor; and

i) elimination of the remaining resin (10c);

characterized in that during stage g) certain number of staircase steps are formed on the edges of the silicon layer (8) by an equal number of successive and partial etching operations of said silicon layer (8), the remaining resin (10a) being used on each occasion as a mask and itself being etched isotropically over a limted thickness following each etching of the silicon layer (8), the staircase steps obtained having a length equal to the resin thickness removed by isotropic etching.

2. Thin film transistor with a self-aligned gate with respect to the drain and source thereof, obtained by the process of claim 1, comprising:

a) the transistor gate (4) on the glass substrate (2);

b) an insulating layer (6) on the substrate (2) and gate (4);

c) a first hydrogenated amorphous silicon layer (8) on the insulating layer (6);

d) second type n+ hydrogenated amorphous silicon layers (12) on the edges of the first silicon layer for producing electrical contacts;

e) conductive layers (14) on the second silicon layers (12) for producing the source and drain electrodes of the transistor;

characterized in that the first hydrogenated amorphous silicon layers (8) have staircase-type edges constituted by at least two steps.

**Patentansprüche**

1. Verfahren zur Herstellung eines Dünnschicht-Transistors mit einem Gitter mit automatischer Ausrichtung auf den Drain und die Source desselben durch Gravieren (Ätzen), das die folgenden aufeinanderfolgenden Stufen umfaßt:

a) Erzeugen des Gitters (4) des Transistors auf einem Glassubstrat (2);

b) Abscheiden einer Isolatorschicht (6) auf dem Substrat (2) und dem Gitter (4);

c) Abscheiden einer dicken Schicht aus hydriertem amorphem Silicium (8) auf der Isolatorschicht (6);

d) Abscheiden einer Schicht aus einem positiv lichtempfindlichen Harz (10) auf dieser Siliciumschicht (8);

e) Bestrahlen der Harzschicht (10) durch das Substrat (2) hindurch, wobei das Gitter (4) als Maske für die Bestrahlung dient;

f) Entwickeln der Harzschicht (10), was zur Eliminierung der bestrahlten Zonen dieser Harzschicht führt;

g) Gravieren (Ätzen) der Siliciumschicht (8) bis zur Freilegung der Isolatorschicht (6), wobei das verbleibende Harz (10a, b, c) als Maske für die Gravierung (Ätzung) dient;

h) Herstellung von elektrischen Kontakten und Elektroden für die Source und den Drain des Transistors; und

i) Eliminierung des verbleibenden Harzes (10c); dadurch gekennzeichnet, daß man im Verlaufe der Stufe g) eine bestimmte Anzahl von Treppenstufen auf den Flanken der Siliciumschicht (8) durch eine gleiche Anzahl von aufeinanderfolgenden und partiellen Gravierungen (Ätzungen) dieser Siliciumschicht (8) erzeugt, wobei das zurückbleibende Harz (10a) jedesmal als Maske dient und selbst in isotroper Weise auf eine geringe Dicke graviert (geätzt) wird am Ende jeder Gravierung (Ätzung) der Siliciumschicht (8), wobei die erhaltenen Treppenstufen eine Länge haben, die gleich der Dicke des durch die isotrope Gravierung entfernten Harzes ist.

2. Dünnschicht-Transistor mit einem Gitter, das automatisch auf den Drain und die Source desselben ausgerichtet ist, wie er nach dem Verfahren gemäß Anspruch 1 erhalten wird, der umfaßt:

a) auf einem Glassubstrat (2) das Gitter (4) des Transistors;

b) auf dem Substrat (2) und dem Gitter (4) eine Isolatorschicht (6);

c) auf der Isolatorschicht (6) eine erste Schicht aus hydriertem amorphem Silicium (8);

d) auf den Flanken der ersten Siliciumschicht (8) zweite Schichten aus hydriertem amorphem Silicium vom $n^+$-Typ (12) zur Herstellung von elektrischen Kontakten;

e) auf den zweiten Siliciumschichten (12) elektrisch leitende Schichten (14) zur Erzeugung von Elektroden für die Source und den Drain des Transistors;

dadurch gekennzeichnet, daß die ersten Schichten aus hydriertem amorphem Silicium (8) Flanken in Form einer Treppe aufweisen, die aus mindestens zwei Stufen besteht.

10

8

6

2                    4

**FIG. 1**

10a

8

6

2        4

**FIG. 2**

10a

8a

6

2        4

**FIG. 3**

FIG. 4

FIG. 5

FIG. 6

FIG. 7

FIG. 8

FIG. 9